(19) Europäisches Patentamt
European Patent Office
Office européen des brevets

(11) **EP 2 995 869 B1**

(12) **EUROPEAN PATENT SPECIFICATION**

(45) Date of publication and mention
of the grant of the patent:
**22.04.2020 Bulletin 2020/17**

(21) Application number: **15184585.6**

(22) Date of filing: **10.09.2015**

(51) Int Cl.:
**F24D 3/10** *(2006.01)* **F25B 23/00** *(2006.01)*

(54) **ARRANGEMENT AND METHOD FOR COOLING LIQUID-COOLED ELECTRONICS**

ANORDNUNG UND VERFAHREN ZUR KÜHLUNG VON FLÜSSIGKEITSGEKÜHLTER
ELEKTRONIK

AGENCEMENT ET PROCÉDÉ POUR REFROIDIR DES COMPOSANTS ÉLECTRONIQUES
REFROIDIS PAR LIQUIDE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **15.09.2014 DE 102014013653**

(43) Date of publication of application:
**16.03.2016 Bulletin 2016/11**

(73) Proprietor: **Adwatec Oy
36220 Kangasala (FI)**

(72) Inventors:
• **Terävä, Jorma
36220 Kangasala (FI)**

• **Verronen, Arto
36220 Kangasala (FI)**

(74) Representative: **Kolster Oy Ab
(Salmisaarenaukio 1)
P.O. Box 204
00181 Helsinki (FI)**

(56) References cited:
**DE-A1- 3 602 489 DE-A1- 3 602 511
DE-A1- 4 125 528 DE-T2- 69 102 356
US-A1- 2005 126 747**

EP 2 995 869 B1

## Description

### Background

The invention relates to an arrangement for cooling liquid-cooled electronics.

The invention further relates to a method for cooling liquid-cooled electronics.

Cooling arrangements and systems for cooling SVC (Static VAR Compensator) systems etc. by circulating liquid coolant are commonly known. In these arrangements the heat energy is transferred from the coolant into air or another liquid by a heat exchanger.

Said cooling arrangements are usually complicated and comprise lot of joints and gaskets. Therefore, there is a potential risk for leakage in said cooling arrangements.

A problem with this is that the leakage is usually difficult to notice prior to a significant amount of the coolant is lost and/or the leaking component is badly damaged. At that point the repairing of the component may hamper the use of the system to be cooled or even necessitate running down the system. Document US2005/126747 A1 discloses an arrangement for cooling liquid-cooled electronics according to the preamble of claim 1.

### Brief description

Viewed from a first aspect, the current invention provides an arrangement for cooling liquid-cooled electronics according to claim 1. Such an arrangement comprises a pipe system, said pipe system comprising receiving and exit coolant flow pipes for connecting the arrangement to a liquid-cooling system of said liquid-cooled electronics, inlet and outlet coolant flow pipes for connecting the arrangement to a heat exchanger arrangement, and an expansion tank connected to the coolant flow pipes, the arrangement further comprising a coolant level transmitter arranged to detect the amount of the coolant in the expansion tank, a temperature measure arrangement arranged for measuring temperature of the coolant in the arrangement, and a leakage control system, comprising a calculation means for calculating a temperature corrected reference value for the amount of the coolant in the expansion tank and for calculating a temperature corrected coolant volume by using said temperature corrected reference value.

Viewed from a further aspect, the current invention provides a method for cooling liquid-cooled electronics according to claim 12. Such a method comprises: receiving coolant flow from the liquid-cooling system of said liquid-cooled electronics in a pipe system, feeding coolant flow to a heat exchanger arrangement, receiving cooled coolant flow from the heat exchanger arrangement to the pipe system, and feeding cooled coolant flow back from the pipe system to the liquid-cooling system of said liquid-cooled electronics, wherein said pipe system further comprises an expansion tank containing said coolant, whereby the method further comprises: detecting the amount of the coolant in the expansion tank, measuring temperature of the coolant in the arrangement, and compensating result by calculating of coolant thermal expansion in the arrangement based on said temperature measurement.

The arrangement and the method are characterised by what is stated in the characterising parts of the independent claims. Some other embodiments are characterised by what is stated in the other claims. Inventive embodiments are also disclosed in the specification and drawings of this patent application. The inventive content of the patent application may also be defined in other ways than defined in the following claims. The inventive content may also be formed of several separate inventions, especially if the invention is examined in the light of expressed or implicit sub-tasks or in view of obtained benefits or benefit groups. Some of the definitions contained in the following claims may then be unnecessary in view of the separate inventive ideas. Features of the different embodiments of the invention may, within the scope of the basic inventive idea, be applied to other embodiments.

### Brief description of figures

Some embodiments illustrating the present disclosure are described in more detail in the attached drawings, in which

Figure 1 is a schematic flow chart of an example arrangement, and
Figure 2 is a schematic perspective view of an example arrangement.

In the figures, some embodiments are shown simplified for the sake of clarity. Similar parts are marked with the same reference numbers in the figures.

### Detailed description

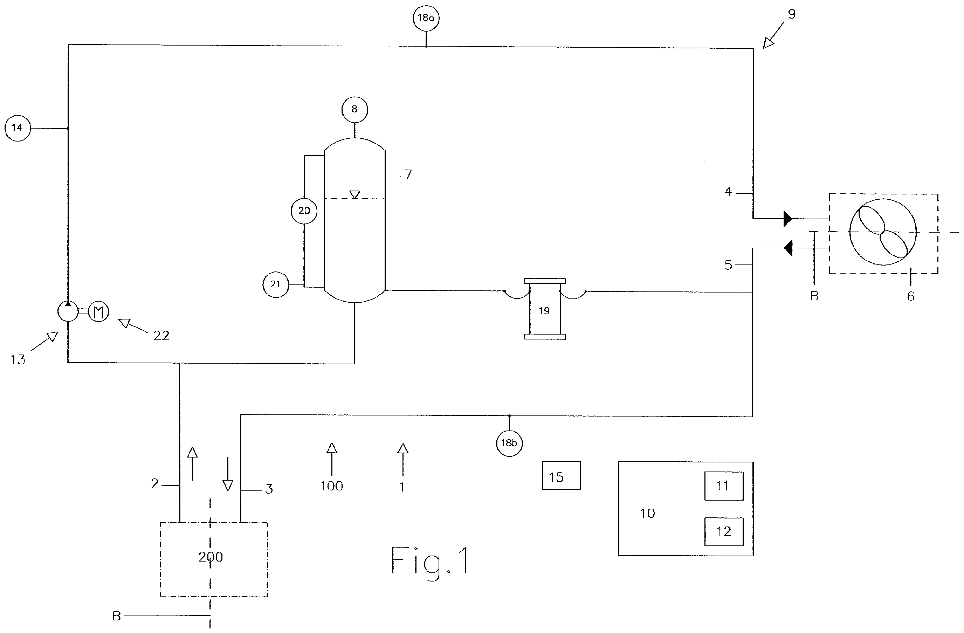

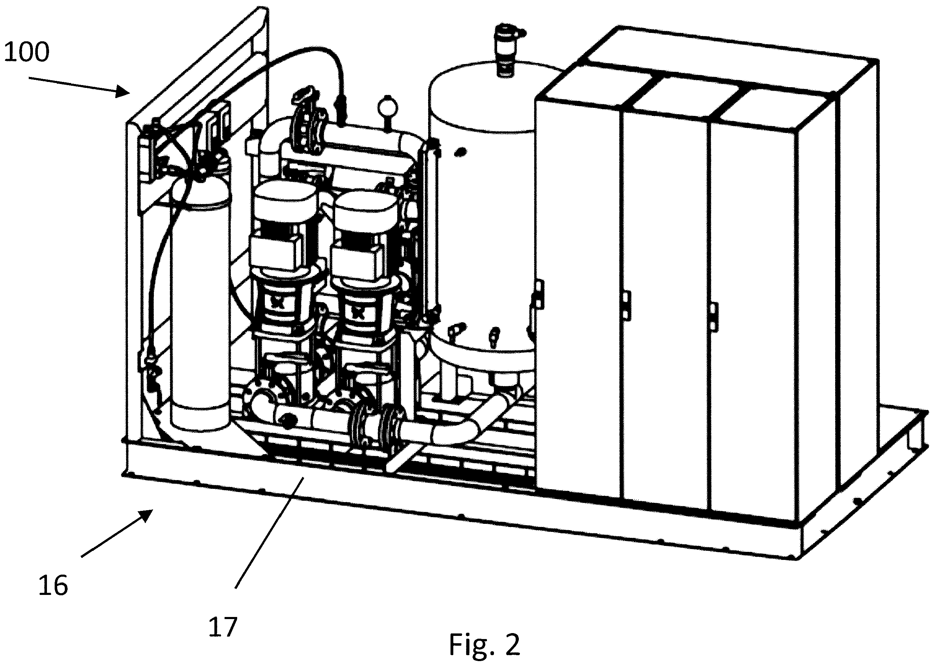

Figure 1 is a schematic flow chart of an example arrangement, and Figure 2 is a schematic perspective view of an example arrangement. The arrangement 100 shown is connected to a liquid-cooling system of a liquid-cooled electronics 200 for cooling said electronics 200. The liquid-cooled electronics 200 may be e.g. a SVC (Static VAR Compensator) unit, or a HVDC/HVAC (High Voltage DC/High Voltage AC) unit, or an AC Drive, an electrical motor, a transformer, a generator, a converter or other liquid-cooled power electric system.

The arrangement 100 circulates coolant between the liquid-cooled electronics 200 and a heat exchanger arrangement 6. For this purpose the arrangement 100 includes a pipe system 1, which comprises receiving 2 and exit 3 coolant flow pipes, and feeding 4 and return 5 coolant flow pipes.

The receiving 2 and exit 3 coolant flow pipes are connected to the liquid-cooling system of the liquid-cooled electronics 200, whereas feeding 4 and return 5 coolant flow pipes are connected to the heat exchanger arrangement 6. Thus there is established a pressurized closed loop cooling circuit comprising the liquid-cooling system of the liquid-cooled electronics 200, the arrangement 100 and the heat exchanger arrangement 6.

The coolant may be e.g. water, de-ionized water or water-alcohol mixture, such as water-glycol or water-ethanol mixture, salt water, liquid salt, oil or other heat transfer fluid.

The heat exchanger arrangement 6 may comprise one or more heat exchangers, where the excessive heat energy of the coolant is transferred to liquid or air, and cooled coolant is returned by the return 5 coolant flow pipes in the arrangement 100. In an embodiment of the invention, the heat exchanger arrangement 6 is included in the arrangement 100, but, however, this is not necessary.

The arrangement may comprise at least one pump 13 for running the coolant in the arrangement 100. The type and operating principle of the pump are known per se.

There are typically significant temperature variations of coolant in the arrangement 100 due to changing heat load in the liquid-cooled electronics 200. Therefore the arrangement 100 comprises an expansion tank 7 that is connected to the coolant flow pipes. The capacity of the expansion tank 7 depends e.g. on ambient temperature range, coolant temperature range and the volume of the coolant circulating in the arrangement 100, in the heat exchanger arrangement and in the liquid-cooling system of a liquid-cooled electronics 200. In an embodiment of the invention, said capacity is 400 litres. The expansion tank 7 may be pressurized over atmospheric pressure.

A temperature measure arrangement 9 is arranged to measure temperature of the coolant in the arrangement 100. The temperature measure arrangement 9 comprises at least one temperature transmitter. The arrangement shown in Figure 1 comprises two temperature transmitters 18a, 18b, the first 18a of which being arranged to measure the temperature of the hot coolant flowing towards the heat exchanger arrangement 6, whereas the second temperature transmitter 18b is arranged to measure the temperature of the cooled coolant flowing towards the liquid-cooling system of the liquid-cooled electronics 200. The type and operating principle of the temperature transmitters are known per se.

The arrangement 100 further comprises at least one coolant level transmitter 8 that is arranged to detect the amount of the coolant in the expansion tank 7. The amount of the coolant in the expansion tank 7 indicates the coolant volume change in the cooling system and it may vary due to e.g. leakage or change of temperature.

According to an embodiment of the invention, the coolant level transmitter 8 is an acoustical sensor, especially an ultrasonic sensor. Alternatively, the coolant level transmitter 8 comprises a mechanical float, a laser or light measuring device, a photoelectric sensor, a conductivity meter, a resistivity meter, an inductive or capacitive meter, a magnetic meter or a weight measuring means arranged to weight the expansion tank 7.

In order to detect possible leakages, the arrangement 100 includes a leakage control system 10. This comprises a calculation means 11 and, in certain embodiments, an alarm means 12.

The calculation means 11 may comprise any known calculation unit, e.g. microprocessor, integrated circuit, programmable logic control etc.

The calculation means 11 is arranged, i.e. programmed to calculate a temperature corrected reference value V(REF) for the amount of the coolant in the expansion tank 7 e.g. according to the following:

$$V(REF) = V(MEAS) - ((TT1 - TT(REF)) \times V1 + (TT2 - TT(REF)) \times V2) \times C1$$

wherein

V(REF) = Temperature corrected coolant volume in the expansion tank 7,
V(MEAS) = Measured coolant volume in the expansion tank 7,
TT1 = Current coolant temperature measured by the first temperature transmitter 18a,
TT(REF) = Reference temperature,
V1 = Cooling system volume of the hot side of the cooling system,
TT2 = Current coolant temperature measured by the second temperature transmitter 18b,
V2 = Cooling system volume in the cool side of the system, including the volume of the coolant purification apparatus and the volume of the expansion tank 7,
C1 = Volumetric thermal expansion coefficient of the coolant.

It should be underlined, that the equation above is just an example of the equations that may be used. For example, if the arrangement comprises one temperature transmitter only, the temperature is measured by said temperature transmitter only.

Boundaries B between the hot side and the cool side of the cooling system may be arranged in suitable points in the heat exchanger arrangement 6 and the liquid-cooled electronics 200. According to an idea, said suitable points are situated in the middle of the volume of the cooling system included in the heat exchanger arrangement 6 and, respectively, in the liquid-cooled electronics 200.

There is a certain frequency in calculating or measuring the temperature corrected reference value V(REF). Based on these consecutive calculations or measurements the leakage control system 10 is able to observe if the volume of the coolant is changing. The use of temperature corrected reference value V(REF) instead of direct use of the coolant level in the expansion tank 7 makes it possible to distinguish coolant level variations being consequences of coolant expansion and contraction with temperature variations from those taking place due to leakages of the coolant system.

The function of the alarm means 12 is arranged to depend on the temperature corrected reference value V(REF) for the amount of the coolant. The alarm means 12 may be programmed to various alarms depending on the rate of the leaking. For example, a major leak alarm will be given if the temperature corrected reference volume of the coolant changes over certain given value in a short period of time, like in 20 seconds, whereas a minor leak alarm will be given if the temperature corrected reference volume of the coolant changes over certain given value in a long period of time, like in one week. It is to be noted, however, that these alarms are just an example of alarms that can be used in the arrangement 100, e.g. there may be just one alarm, or more than two alarms depending on the need of the arrangement 100 and/or the liquid-cooled electronics 200.

The arrangement 100 may, additionally, comprise one or more coolant level indicator(s) 20 and coolant lever switch(s) 21. These components are arranged to be back-up indicators for current or true amount of coolant.

As disclosed earlier, the arrangement 100 may comprise a purification apparatus 19, e.g. an ion exchanger, which is arranged for purification of the coolant. The purification apparatus 19 may be connected to the pipe system 1 to purify a partial coolant flow flowing from the heat exchanger arrangement 6 to the expansion tank 7 as shown in Figure 1. There are also other alternatives to connect the purification apparatus 19 to the pipe system 1. The purification apparatus 19 may be e.g. a mixed bed ion exchanger, a filter, a reverse osmosis unit or any other purification apparatus known per se.

The arrangement 100 shown in the Figures further comprises a pump 13 and a motor 22 operating said pump. The pump 13 is arranged to run the coolant in the arrangement 100 and, optionally, in the liquid-cooled electronics 200. The pump 13 and the motor 22 may be any suitable pump and motor know per se.

There may also be a pressure transmitter 14 arranged for measuring pressure of the coolant in the pipe system 1. The pressure transmitter 14 can not only be used for detecting the pressure of the pipe system 1, but it can also be utilized with means 15 for detecting the residual gas content of the coolant in the pipe system 1. Said means 15 may comprise any known calculation unit, e.g. microprocessor, integrated circuit, programmable logic control etc. In an embodiment of the invention, the means 15 are integrated with the calculation means 11 described above.

The means 15 for detecting the residual gas content of the coolant is fed by pressure information from the pressure transmitter 14. The compression property of the coolant varies depending on the gas content of the coolant. The aim or optimum is that there is no gas in the coolant at all. If the coolant comprises gas, it may compress slightly when the pump 13 is started. The compression of the coolant can be detected by the pressure transmitter 14. The residual gas content is then calculated based on temperature corrected coolant volume in the expansion tank 7 and pressure values when the pump 13 is running and stopped. According to an idea, the residual gas content V(GAS) is calculated as follows:

$$V(GAS) = (P1/(P1-P2)) \times (V(REF, STOP) - V(REF, RUN)) - C$$

wherein

V(GAS) = Estimation of the residual gas volume in the pipe system at expansion tank pressure,
P1 = (Pump pressure - expansion tank pressure)/2 = average pressure rise in the pipe system 1 when the pump 13 is running,
P2 = absolute pressure in the expansion tank 7,
V(REF,STOP) = Temperature corrected coolant volume in the expansion tank 7 when the pump 13 is stopped,

V(REF,RUN) = Temperature corrected coolant volume in the expansion tank 7 when the pump 13 is running,
C = elasticity constant of the pipe system. Usually C is zero, i.e. the elasticity of the pipe system 1 may be ignored as the pressure rise is typically reasonable low.

The means 15 for detecting the residual gas content of the coolant is especially useful in the start-up stage of the arrangement 100, because the means 15 opens up a possibility to detect the moment the pipe system 1 is completely degassed.

It is to be noted here, that at least critical components of the arrangement 100 may be duplicated for giving high reliability.

As can be seen in Figure 2, the arrangement 100 may be an independent module 16 comprising a frame structure 17 in which the pipe system 1 and the expansion tank 7 as well as other components of the arrangement 100 are attached. The module 16 can be easily transported and handled during its installing.

The arrangement may be used to put into practice the following method:

a) receiving coolant flow from the liquid-cooling system of a liquid-cooled electronics 200 in a pipe system 1,
b) feeding a coolant flow to a heat exchanger arrangement 6,
c) receiving a cooled coolant flow from the heat exchanger arrangement 6 to the pipe system 1, and
d) feeding cooled coolant flow back from the pipe system 1 to the liquid-cooling system of said liquid-cooled electronics 200, wherein said pipe system 1 further comprises an expansion tank 7 containing said coolant, whereby the method further comprises:
e) detecting the amount of the coolant in the expansion tank 7,
f) measuring temperature of the coolant in the arrangement (100), and
g) compensating result by calculating of coolant thermal expansion in the arrangement based on said temperature measurement.

The invention is not limited solely to the embodiments described above, but instead many variations are possible within the scope of the inventive concept defined by the claims below. Within the scope of the inventive concept the attributes of different embodiments and applications can be used in conjunction with or replace the attributes of another embodiment or application.

The drawings and the related description are only intended to illustrate the idea of the invention. The invention may vary in detail within the scope of the inventive idea defined in the following claims.

Reference symbols

| 1 | pipe system |
|---|---|
| 2 | receiving coolant flow pipe |
| 3 | exit coolant flow pipe |
| 4 | inlet coolant flow pipe |
| 5 | outlet coolant flow pipe |
| 6 | heat exchanger arrangement |
| 7 | expansion tank |
| 8 | coolant level transmitter |
| 9 | temperature measure arrangement |
| 10 | leakage control system |
| 11 | calculation means |
| 12 | alarm means |
| 13 | pump |
| 14 | pressure transmitter |
| 15 | means for detecting residual gas content |
| 16 | module |
| 17 | frame structure |
| 18a, 18b | temperature transmitter |
| 19 | coolant purification apparatus |
| 20 | coolant level indicator |
| 21 | coolant lever switch |
| 22 | motor |

100     arrangement
200     liquid-cooled electronics

B       Boundary between hot and cool side

**Claims**

1.  An arrangement (100) for cooling liquid-cooled electronics (200), the arrangement (100) comprising a pipe system (1), said pipe system comprising

    receiving (2) and exit (3) coolant flow pipes for connecting the arrangement (100) to a liquid-cooling system of said liquid-cooled electronics (200),
    inlet (4) and outlet (5) coolant flow pipes for connecting the arrangement (100) to a heat exchanger arrangement (6), and
    an expansion tank (7) connected to the coolant flow pipes, the arrangement (100) further comprising

    a coolant level transmitter (8) arranged to detect the volume of the coolant in the expansion tank (7),
    a temperature measure arrangement (9) arranged for measuring temperature of the coolant in the arrangement (100), and
    a leakage control system (10), **characterized in that**
    the leakage control system (10) comprises
    a calculation means (11) configured to observe if the volume of the coolant is changing based on consecutive calculations of a temperature corrected reference value (V(REF)) for the volume of the coolant in the expansion tank (7), wherein the use of the temperature corrected reference value (V(REF)) instead of direct use of the detected volume of the coolant in the expansion tank (7) makes it possible to distinguish coolant level variations being consequences of coolant expansion and contraction with temperature variations from those taking place due to leakages of the coolant system.

2.  The arrangement as claimed in claim 1, the arrangement (100) being a cooling station of a SVC (Static VAR Compensator) unit, a HVDC/HVAC (High Voltage DC/High Voltage AC) unit, an AC Drive, an electrical motor, a transformer, a generator, and/or a converter.

3.  The arrangement as claimed in claim 1 or 2, comprising a pump (13) for running the coolant in the arrangement (100).

4.  The arrangement as claimed in any one of the preceding claims, comprising a pressure transmitter (14) arranged for measuring pressure of the coolant in the pipe system (1).

5.  The arrangement as claimed in claims 1 to 2, comprising
    a pump (13) for running the coolant in the arrangement (100),
    a pressure transmitter (14) arranged for measuring pressure of the coolant in the pipe system (1), and
    means (15) for detecting the compression property of the coolant in the pipe system (1) on the basis of the pressure of the coolant and the operation of the pump (13).

6.  The arrangement as claimed in any one of the preceding claims, wherein the coolant is water, de-ionized water or water-glycol mixture.

7.  The arrangement as claimed in any one of the preceding claims, wherein the arrangement (100) is an independent module (16) comprising a frame structure (17) in which the pipe system (1) and the expansion tank (7) are attached.

8.  The arrangement as claimed in any one of the preceding claims, wherein the coolant level transmitter (8) is an acoustical sensor, such as an ultrasonic sensor, a mechanical float, a laser or light measuring device, a photoelectric sensor, a conductivity meter, a resistivity meter, an inductive or capacitive meter, a magnetic meter, and/or a weight measuring means arranged to weight the expansion tank (7).

9.  The arrangement as claimed in any one of the preceding claims, wherein the temperature measure arrangement (9) comprises at least two temperature transmitters (18a, 18b),

- first of which being arranged to measure the temperature of the hot coolant flowing towards the heat exchanger arrangement (6), and
- another of which being arranged to measure the temperature of the cooled coolant flowing away from the heat exchanger arrangement (6).

10. The arrangement as claimed in any one of the preceding claims, comprising an alarm means (12) arranged to induce an alarm in case the temperature corrected coolant volume value fulfils conditions set for the alarm.

11. The arrangement as claimed in any one of the preceding claims, comprising means (15) for detecting the residual gas content of the coolant in the pipe system (1).

12. A method for cooling liquid-cooled electronics (200), the method comprising

- receiving coolant flow from the liquid-cooling system of said liquid-cooled electronics (200) in a pipe system (1),
- feeding coolant flow to a heat exchanger arrangement (6),
- receiving cooled coolant flow from the heat exchanger arrangement (6) to the pipe system (1), and
- feeding cooled coolant flow back from the pipe system (1) to the liquid-cooling system of said liquid-cooled electronics (200), wherein said pipe system (1) further comprises
- an expansion tank (7) containing said coolant, whereby the method further comprises
- detecting the volume of the coolant in the expansion tank (7),
- measuring temperature of the coolant in the arrangement (100), **characterized by**
- calculating a temperature corrected reference value (V(REF)) for the volume of the coolant in the expansion tank (7) to observe if the volume of the coolant is changing based on consecutive calculations of the temperature corrected reference value (V(REF)) for the volume of the coolant in the expansion tank (7), wherein the use of the temperature corrected reference value (V(REF)) instead of direct use of the detected volume of the coolant in the expansion tank (7) makes it possible to distinguish coolant level variations being consequences of coolant expansion and contraction with temperature variations from those taking place due to leakages of the coolant system.

13. The method as claimed in claim 12, further comprising inducing an alarm in case the temperature corrected reference value fulfils conditions set for the alarm.

14. The method as claimed in claim 12 or 13, comprising:

- running the coolant with a pump (13),
- comparing the temperature corrected coolant volume when the pump (13) is running and when the pump (13) is stopped,
- calculating a residual gas content in the pipe system (1) by comparing the temperature corrected coolant volumes and pressure values when pump is running and stopped.

**Patentansprüche**

1. Anordnung (100) zur Kühlung von flüssigkeitsgekühlter Elektronik (200), wobei die Anordnung (100) umfasst: ein Rohrleitungssystem (1), wobei das Rohrleitungssystem umfasst:

Rohrleitungen für den Kühlmittelzulauf (2) und Kühlmittelablauf (3), die die Anordnung (100) mit einem Flüssigkeitskühlsystem der flüssigkeitsgekühlten Elektronik (200) verbinden,
Rohrleitungen für den Kühlmitteleinlass (4) und Kühlmittelauslass (5), die die Anordnung (100) mit einer Wärmetauscheranordnung (6) verbinden, und
einen Ausdehnungsbehälter (7), der mit den Kühlmittelrohrleitungen verbunden ist, wobei die Anordnung (100) ferner umfasst:

einen Kühlmittelniveaugeber (8), der dafür ausgelegt ist, das Volumen des Kühlmittels in dem Ausdehnungsbehälter (7) zu erkennen,
eine Temperaturmessanordnung (9), die dafür ausgelegt ist, die Temperatur des Kühlmittels in der Anordnung (100) zu messen, und
ein Leckagekontrollsystem (10), **dadurch gekennzeichnet, dass**

das Leckagekontrollsystem (10) Berechnungsmittel (11) umfasst, die dafür konfiguriert sind, basierend auf aufeinanderfolgenden Berechnungen eines temperaturkorrigierten Referenzwertes (V(REF)) für das Volumen des Kühlmittels in dem Ausdehnungsbehälter (7) zu beobachten, ob sich das Volumen des Kühlmittels ändert, wobei es die Verwendung des temperaturkorrigierten Referenzwertes (V(REF)) anstelle der direkten Verwendung des erkannten Volumens des Kühlmittels in dem Ausdehnungsbehälter (7) ermöglicht, Schwankungen des Kühlmittelniveaus infolge der Ausdehnung und der Kontraktion des Kühlmittels bei Temperaturschwankungen von denjenigen zu unterscheiden, die aufgrund von Leckagen des Kühlmittelsystems stattfinden.

2. Anordnung nach Anspruch 1, wobei die Anordnung (100) eine Kühlstation einer statischen Blindleistungskompensator-Vorrichtung, einer Hochspannungs-Gleichstrom- bzw. Hochspannungs-Drehstrom-Übertragungsvorrichtung, eines Wechselstromantriebs, eines Elektromotors, eines Transformators, eines Generators und/oder eines Umrichters ist.

3. Anordnung nach Anspruch 1 oder 2 umfassend eine Pumpe (13) für die Zirkulation des Kühlmittels in der Anordnung (100) .

4. Anordnung nach einem der vorstehenden Ansprüche umfassend einen Druckgeber (14), der dafür ausgelegt ist, den Druck des Kühlmittels in dem Rohrleitungssystem (1) zu messen.

5. Anordnung nach der Ansprüche 1 bis 2 umfassend:

   eine Pumpe (13) für die Zirkulation des Kühlmittels in der Anordnung (100),
   einen Druckgeber (14), der dafür ausgelegt ist, den Druck des Kühlmittels in dem Rohrleitungssystem (1) zu messen, und
   Mittel (15) zum Erkennen der Verdichtungseigenschaft des Kühlmittels in dem Rohrleitungssystem (1) anhand des Drucks des Kühlmittels und des Betriebs der Pumpe (13).

6. Anordnung nach einem der vorstehenden Ansprüche, wobei das Kühlmittel Wasser, deionisiertes Wasser oder ein Wasser-Glykol-Gemisch ist.

7. Anordnung nach einem der vorstehenden Ansprüche, wobei die Anordnung (100) ein unabhängiges Modul (16) ist, das eine Rahmenstruktur (17) umfasst, in dem das Rohrleitungssystem (1) und der Ausdehnungsbehälter (7) befestigt sind.

8. Anordnung nach einem der vorstehenden Ansprüche, wobei der Kühlmittelniveaugeber (8) ein akustischer Sensor, wie beispielsweise ein Ultraschallsensor, ein mechanischer Schwimmer, eine Laser- oder Lichtmessvorrichtung, eine Lichtschranke, ein Leitfähigkeitsmessgerät, ein Widerstandsmessgerät, ein induktives oder kapazitives Messgerät, ein magnetisches Messgerät und/oder eine Gewichtsmessvorrichtung ist, die dafür ausgelegt ist, den Ausdehnungsbehälter (7) zu wiegen.

9. Anordnung nach einem der vorstehenden Ansprüche, wobei die Temperaturmessanordnung (9) mindestens zwei Temperaturmessumformer (18a, 18b) umfasst,

   - von denen der erste dafür ausgelegt ist, die Temperatur des heißen Kühlmittels zu messen, das in Richtung der Wärmetauscheranordnung (6) fließt, und
   - von denen der andere dafür ausgelegt ist, die Temperatur des gekühlten Kühlmittels zu messen, das von der Wärmetauscheranordnung (6) weg fließt.

10. Anordnung nach einem der vorstehenden Ansprüche umfassend eine Alarmeinrichtung (12), die dafür ausgelegt ist, einen Alarm auszulösen, falls der temperaturkorrigierte Kühlmittelvolumenwert für den Alarm eingestellte Bedingungen erfüllt.

11. Anordnung nach einem der vorstehenden Ansprüche umfassend Mittel (15) zum Erkennen des Restgasgehalts des Kühlmittels in dem Rohrleitungssystem (1).

12. Verfahren zur Kühlung von flüssigkeitsgekühlter Elektronik (200), wobei das Verfahren umfasst:

- Aufnehmen von Kühlmittelfluss von dem Flüssigkeitskühlsystem der flüssigkeitsgekühlten Elektronik (200) in einem Rohrleitungssystem (1),
- Zuführen von Kühlmittelfluss zu einer Wärmetauscheranordnung (6),
- Aufnehmen des gekühlten Kühlmittelflusses von der Wärmetauscheranordnung (6) in dem Rohrleitungssystem (1), und
- Zurückführen des gekühlten Kühlmittelflusses aus dem Rohrleitungssystem (1) in das Flüssigkeitskühlsystem der flüssigkeitsgekühlten Elektronik (200), wobei das Rohrleitungssystem (1) ferner umfasst:

- einen Ausdehnungsbehälter (7), der das Kühlmittel enthält, wobei das Verfahren ferner umfasst:

- Erkennen des Volumens des Kühlmittels in dem Ausdehnungsbehälter (7),
- Messen der Temperatur des Kühlmittels in der Anordnung (100), **gekennzeichnet durch**
- Berechnen eines temperaturkorrigierten Referenzwertes (V(REF)) für das Volumen des Kühlmittels in dem Ausdehnungsbehälter (7), um basierend auf aufeinanderfolgenden Berechnungen des temperaturkorrigierten Referenzwertes (V(REF)) für das Volumen des Kühlmittels in dem Ausdehnungsbehälter (7) zu beobachten, ob sich das Volumen des Kühlmittels ändert, wobei es die Verwendung des temperaturkorrigierten Referenzwertes (V(REF)) anstelle der direkten Verwendung des erkannten Volumens des Kühlmittels in dem Ausdehnungsbehälter (7) ermöglicht, Schwankungen des Kühlmittelniveaus infolge der Ausdehnung und der Kontraktion des Kühlmittels bei Temperaturschwankungen von denjenigen zu unterscheiden, die aufgrund von Leckagen des Kühlmittelsystems stattfinden.

13. Verfahren nach Anspruch 12, das ferner das Auslösen eines Alarms umfasst, falls der temperaturkorrigierte Referenzwert die für den Alarm eingestellten Bedingungen erfüllt.

14. Verfahren nach Anspruch 12 oder 13 umfassend:

- Fördern des Kühlmittels mit einer Pumpe (13),
- Vergleichen des temperaturkorrigierten Kühlmittelvolumens, wenn die Pumpe (13) läuft und wenn die Pumpe (13) gestoppt wird,
- Berechnen eines Restgasgehalts in dem Rohrleitungssystem (1) durch Vergleichen der temperaturkorrigierten Kühlmittel-Volumenwerte und -Druckwerte, wenn die Pumpe läuft und gestoppt wird.

**Revendications**

1. Agencement (100) pour refroidir une électronique refroidie par liquide (200), l'agencement (100) comprenant :
un système de tuyaux (1), ledit système de tuyaux comprenant :

des tuyaux d'écoulement de liquide de refroidissement de réception (2) et de sortie (3) pour relier l'agencement (100) à un système de refroidissement par liquide de ladite électronique refroidie par liquide (200),
des tuyaux d'écoulement de liquide de refroidissement d'entrée (4) et de sortie (5) pour relier l'agencement (100) à un agencement d'échangeur de chaleur (6), et
un réservoir d'expansion (7) relié aux tuyaux d'écoulement de liquide de refroidissement, l'agencement (100) comprenant en outre :

un émetteur de niveau de liquide de refroidissement (8) agencé pour détecter le volume du liquide de refroidissement dans le réservoir d'expansion (7),
un agencement de mesure de température (9) agencé pour mesurer la température du liquide de refroidissement dans l'agencement (100), et
un système de contrôle de fuite (10), **caractérisé en ce que**
le système de contrôle de fuite (10) comprend des moyens de calcul (11) configurés pour observer si le volume du liquide de refroidissement change sur la base de calculs consécutifs d'une valeur de référence corrigée en température (V(REF)) pour le volume du liquide de refroidissement dans le réservoir d'expansion (7), dans lequel l'utilisation de la valeur de référence corrigée en température (V(REF)) au lieu de l'utilisation directe du volume détecté du liquide de refroidissement dans le réservoir d'expansion (7) permet de distinguer les variations de niveau de liquide de refroidissement qui sont les conséquences de l'expansion et de la contraction du liquide de refroidissement avec les variations de température de celles qui ont lieu du fait de fuites du système de liquide de refroidissement.

**2.** Agencement selon la revendication 1, dans lequel l'agencement (100) est un poste de refroidissement d'une unité à compensateur statique d'énergie réactive, d'une unité à courant continu haute tension/courant alternatif haute tension, d'un système de commande à courant alternatif, d'un moteur électrique, d'un transformateur, d'une génératrice, et/ou d'un convertisseur.

**3.** Agencement selon la revendication 1 ou 2, comprenant une pompe (13) pour la circulation du liquide de refroidissement dans l'agencement (100).

**4.** Agencement selon l'une quelconque des revendications précédentes, comprenant un émetteur de pression (14) agencé pour mesurer la pression du liquide de refroidissement dans le système de tuyaux (1).

**5.** Agencement selon les revendications 1 à 2, comprenant :

une pompe (13) pour la circulation du liquide de refroidissement dans l'agencement (100),
un émetteur de pression (14) agencé pour mesurer la pression du liquide de refroidissement dans le système de tuyaux (1), et
des moyens (15) pour détecter la propriété de compression du liquide de refroidissement dans le système de tuyaux (1) sur la base de la pression du liquide de refroidissement et du fonctionnement de la pompe (13).

**6.** Agencement selon l'une quelconque des revendications précédentes, dans lequel le liquide de refroidissement est de l'eau, de l'eau désionisée ou un mélange eau-glycol.

**7.** Agencement selon l'une quelconque des revendications précédentes, dans lequel l'agencement (100) est un module indépendant (16) comprenant une structure de cadre (17) dans laquelle le système de tuyaux (1) et le réservoir d'expansion (7) sont attachés.

**8.** Agencement selon l'une quelconque des revendications précédentes, dans lequel l'émetteur de niveau de liquide de refroidissement (8) est un capteur acoustique, tel qu'un capteur ultrasonore, un flotteur mécanique, un dispositif de mesure laser ou lumineux, un capteur photoélectrique, un conductivimètre, un résistivimètre, un inductancemètre ou un capacimètre, un magnétomètre, et/ou des moyens de mesure de poids agencés pour peser le réservoir d'expansion (7).

**9.** Agencement selon l'une quelconque des revendications précédentes, dans lequel l'agencement de mesure de température (9) comprend au moins deux émetteurs de température (18a, 18b),

- le premier étant agencé pour mesurer la température du liquide de refroidissement chaud qui s'écoule vers l'agencement d'échangeur de chaleur (6), et
- un autre étant agencé pour mesurer la température du liquide de refroidissement refroidi qui s'écoule hors de l'agencement d'échangeur de chaleur (6).

**10.** Agencement selon l'une quelconque des revendications précédentes, comprenant des moyens d'alarme (12) agencés pour induire une alarme dans le cas où la valeur de volume de liquide de refroidissement corrigée en température satisfait à des conditions établies pour l'alarme.

**11.** Agencement selon l'une quelconque des revendications précédentes, comprenant des moyens (15) pour détecter la teneur en gaz résiduel du liquide de refroidissement dans le système de tuyaux (1).

**12.** Procédé pour refroidir une électronique refroidie par liquide (200), le procédé comprenant :

- la réception d'un écoulement de liquide de refroidissement du système de refroidissement par liquide de ladite électronique refroidie par liquide (200) dans un système de tuyaux (1),
- la fourniture de l'écoulement de liquide de refroidissement à un agencement d'échangeur de chaleur (6),
- la réception de l'écoulement de liquide de refroidissement refroidi de l'agencement d'échangeur de chaleur (6) vers le système de tuyaux (1), et
- la fourniture de l'écoulement de liquide de refroidissement refroidi de retour du système de tuyaux (1) au système de refroidissement par liquide de ladite électronique refroidie par liquide (200), dans lequel ledit système de tuyaux (1) comprend en outre :
- un réservoir d'expansion (7) qui contient ledit liquide de refroidissement, moyennant quoi le procédé comprend en outre :

- la détection du volume du liquide de refroidissement dans le réservoir d'expansion (7),
- la mesure de la température du liquide de refroidissement dans l'agencement (100), **caractérisé par**
- le calcul d'une valeur de référence corrigée en température (V(REF)) pour le volume du liquide de refroidissement dans le réservoir d'expansion (7) pour observer si le volume du liquide de refroidissement change sur la base de calculs consécutifs de la valeur de référence corrigée en température (V(REF)) pour le volume du liquide de refroidissement dans le réservoir d'expansion (7), dans lequel l'utilisation de la valeur de référence corrigée en température (V(REF)) au lieu de l'utilisation directe du volume détecté du liquide de refroidissement dans le réservoir d'expansion (7) permet de distinguer les variations de niveau de liquide de refroidissement qui sont les conséquences de l'expansion et de la contraction du liquide de refroidissement avec les variations de température de celles qui ont lieu du fait de fuites du système de liquide de refroidissement.

13. Procédé selon la revendication 12, comprenant en outre la génération d'une alarme dans le cas où la valeur de référence corrigée en température satisfait à des conditions établies pour l'alarme.

14. Procédé selon la revendication 12 ou 13, comprenant :

- la mise en circulation du liquide de refroidissement avec une pompe (13),
- la comparaison du volume de liquide de refroidissement corrigé en température lorsque la pompe (13) fonctionne et lorsque la pompe (13) est arrêtée,
- le calcul d'une teneur en gaz résiduel dans le système de tuyaux (1) en comparant les volumes de liquide de refroidissement corrigés en température et les valeurs de pression lorsque la pompe fonctionne et lorsqu'elle est arrêtée.

Fig.1

Fig. 2

**EP 2 995 869 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2005126747 A1